(19) Europäisches Patentamt / European Patent Office / Office européen des brevets

(11) **EP 2 602 814 A1**

(12) **EUROPEAN PATENT APPLICATION**
published in accordance with Art. 153(4) EPC


(43) Date of publication:
**12.06.2013 Bulletin 2013/24**

(21) Application number: **11814708.1**

(22) Date of filing: **04.08.2011**

(51) Int Cl.:
***H01L 21/301*** *(2006.01)* ***C09J 7/02*** *(2006.01)*
***C09J 133/04*** *(2006.01)* ***H01L 21/683*** *(2006.01)*

(86) International application number:
**PCT/JP2011/067873**

(87) International publication number:
**WO 2012/018083 (09.02.2012 Gazette 2012/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.08.2010 JP 2010177942**



(71) Applicant: **Nitto Denko Corporation**
**Ibaraki-shi, Osaka 567-8680 (JP)**

(72) Inventors:
- **HIGASHIBEPPU,Yuki**
  **Ibaraki-shi**
  **Osaka 567-8680 (JP)**
- **YAMAMOTO,Akiyoshi**
  **Ibaraki-shi**
  **Osaka 567-8680 (JP)**

(74) Representative: **Grünecker, Kinkeldey,**
**Stockmair & Schwanhäusser**
**Leopoldstrasse 4**
**80802 München (DE)**


(54) **ELECTRONIC COMPONENT MANUFACTURING METHOD**


(57) There is provided a method of producing an electronic component capable of preventing electrostatic destruction on a circuit or the like formed on the electronic component by eliminating the electrification charge generated on a pressure-sensitive adhesive sheet efficiently in a short period of time upon producing the electronic component using the pressure-sensitive adhesive sheet. The present invention is a method of producing an electronic component using a pressure-sensitive adhesive sheet in which at least a pressure-sensitive adhesive layer and a separator are sequentially stacked on a base material, the pressure-sensitive adhesive sheet having 900 seconds or less of a half-value period of the electrification charge generated on a surface of said pressure-sensitive adhesive layer by the charge decay measuring method based on JIS L1094, at least comprising: a step of peeling said separator off from said pressure-sensitive adhesive layer; a step of eliminating the electrification charge on the surface of said pressure-sensitive adhesive layer; and a step of bonding an electronic component onto said pressure-sensitive adhesive layer after charge elimination.


FIG. 1

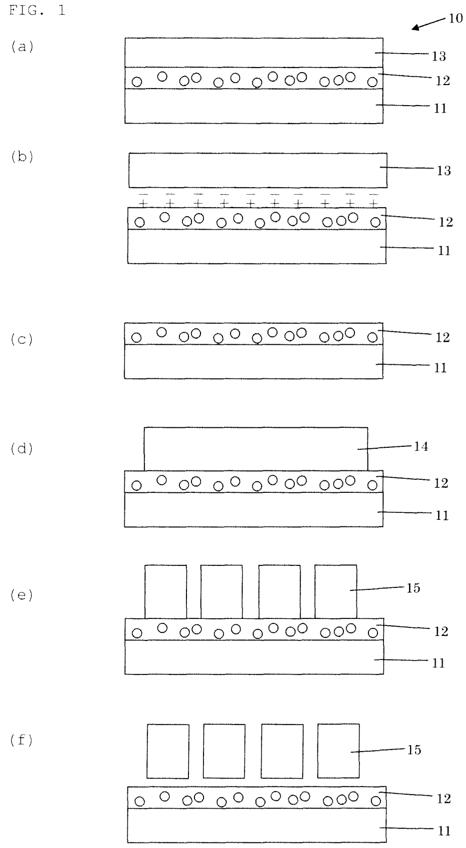


EP 2 602 814 A1

## Description

### TECHNICAL FIELD

The present invention relates to a method of producing an electronic component using a pressure-sensitive adhesive sheet constructed by stacking at least a pressure-sensitive adhesive layer and a separator sequentially on a base material and having an charge elimination effect.

### BACKGROUND ART

In recent years, in accordance with higher refinement and higher integration of electronic components represented by semiconductor devices, there is a concern that charging of the electronic components in the production process affects the later-imparted characteristics. For example, in dicing a semiconductor wafer during the process of producing a semiconductor device, a pressure-sensitive adhesive sheet for dicing is bonded onto the back surface of the semiconductor wafer. The pressure-sensitive adhesive sheet has, for example, a structure in which a pressure-sensitive adhesive layer and a separator are sequentially stacked on a base material. The separator is peeled off at the time of use of the pressure-sensitive adhesive sheet. Upon peeling off, electrification charge may be generated on the surfaces of the separator and the pressure-sensitive adhesive layer that have been separated into two, thereby to charge the surfaces. When a semiconductor wafer is bonded onto the pressure-sensitive adhesive layer in such a charged state, electric discharge to the semiconductor wafer may occur. This results in a problem that, in some cases, the circuit formed on the semiconductor wafer surface may be destroyed and fail to operate normally.

To cope with this problem, the following patent document 1 discloses an invention of reducing the amount of electrification charge generated on the surface of the pressure-sensitive adhesive layer by adding an antistatic agent such as a surfactant into the pressure-sensitive adhesive layer. However, in recent years, when semiconductor devices as electronic components are viewed, scale reduction is greatly progressing, so that the holding property of the semiconductor wafers during the processing is becoming important in order to enable precision processing together with prevention of electrification. With a conventional pressure-sensitive adhesive layer to which an antistatic agent is added, the adhesive strength may decrease by segregation of the antistatic agent on the pressure-sensitive adhesive layer surface, making it impossible to perform precision processing. Also, by addition of the antistatic agent alone, reduction of the electrification potential on the pressure-sensitive adhesive layer surface may be in some cases insufficient, raising a fear of still leading to a situation in which the circuit on the semiconductor wafer surface is destroyed and fails to operate normally.

### PRIOR ART DOCUMENTS

### PATENT DOCUMENTS

Patent document 1: JP-A-2002-285134

### SUMMARY OF THE INVENTION

### PROBLEMS TO BE SOLVED BY THE INVENTION

The present invention has been made in view of the aforementioned problems, and an object thereof is to provide a method of producing an electronic component capable of preventing electrostatic destruction on a circuit or the like formed on the electronic component by eliminating the electrification charge generated on a pressure-sensitive adhesive sheet efficiently in a short period of time in producing the electronic component using the pressure-sensitive adhesive sheet.

### MEANS FOR SOLVING THE PROBLEMS

In order to solve the aforementioned problems of the prior art, the inventors of the present application have made studies on a method of producing an electronic component. As a result of this, the inventors have found out that the aforementioned problems can be solved by adopting the following construction, thereby completing the present invention.

Thus, in order to solve the aforementioned problems, the method of producing an electronic component according to the present invention is a method of producing an electronic component using a pressure-sensitive adhesive sheet in which at least a pressure-sensitive adhesive layer and a separator are sequentially stacked on a base material,

the pressure-sensitive adhesive sheet having 900 seconds or less of a half-value period of the electrification charge generated on a surface of said pressure-sensitive adhesive layer by the charge decay measuring method based on JIS L1094, at least comprising: a step of peeling said separator off from said pressure-sensitive adhesive layer; a step of eliminating the electrification charge on the surface of said pressure-sensitive adhesive layer; and a step of bonding an electronic component onto said pressure-sensitive adhesive layer after charge elimination.

In a pressure-sensitive adhesive layer whose surface is protected with a separator, electrification charge may be generated on the surface of the pressure-sensitive adhesive layer when the separator is peeled off. This generated electrification charge can be removed or reduced by performing charge elimination before bonding an electronic component onto the pressure-sensitive adhesive layer. Here, in the present invention, as the pressure-sensitive adhesive sheet, a pressure-sensitive adhesive sheet provided with a pressure-sensitive adhesive layer that a half-value period of the electrification charge generated on the surface thereof is 900 seconds or less by the charge decay measuring method based on JIS L1094 is used. With such a pressure-sensitive adhesive sheet, charge elimination on the surface of the pressure-sensitive adhesive layer can be carried out efficiently in a short period of time. Therefore, when an electronic component is bonded onto the pressure-sensitive adhesive layer, electric discharge to the electronic component can be sufficiently restrained. As a result thereof, an improvement in the production yield of the electronic component can be achieved.

In the aforesaid construction, it is preferable to use, as said pressure-sensitive adhesive sheet, one in which ionic liquid within a range of 0.01 part by weight to 30 parts by weight is added to said pressure-sensitive adhesive layer relative to 100 parts by weight of a base polymer thereof. When ionic liquid is added into the pressure-sensitive adhesive layer, electrical conductivity can be imparted to the pressure-sensitive adhesive layer. As a result thereof, electric discharge is promoted even if electrification charge is generated on the surface of the pressure-sensitive adhesive layer by peeling-off of the separator, thereby facilitating the charge elimination. Also, since the ionic liquid can be let to be present uniformly in the pressure-sensitive adhesive layer, the generated electrification charge can be effectively removed over the whole surface of the pressure-sensitive adhesive layer. Here, by setting the amount of addition of the ionic liquid to be 0.01 part by weight or more relative to 100 parts by weight of the base polymer of the pressure-sensitive adhesive layer, the generated electrification charge can be effectively removed over the whole surface of the pressure-sensitive adhesive layer. On the other hand, by setting the aforesaid amount of addition to be 30 parts by weight or less relative to 100 parts by weight of the base polymer of the pressure-sensitive adhesive layer, contamination at the time of peeling-off of the pressure-sensitive adhesive sheet from the electronic component can be prevented.

In the aforesaid construction, it is preferable that the base polymer in said pressure-sensitive adhesive layer of said pressure-sensitive adhesive sheet is at least formed of an acryl polymer formed of at least one of an acrylate having an alkyl group with a carbon number of 1 to 14 and a methacrylate having an alkyl group with a carbon number of 1 to 14, and a monomer having a high polarity, and that said monomer having a high polarity is blended in an amount of 0.1 part by weight or more relative to 100 parts by weight of said acryl polymer. By using a pressure-sensitive adhesive sheet in which 0.1 part by weight or more of a polymer having a high polarity is blended relative to 100 parts by weight of said acryl polymer, compatibility between the base polymer and the ionic liquid can be improved. This can prevent segregation of the ionic liquid onto the pressure-sensitive adhesive layer surface and can restrain the decrease in the adhesive strength of the pressure-sensitive adhesive layer. As a result thereof, when dicing of a semiconductor wafer, for example, is carried out as processing of an electronic component, semiconductor chips made into individual pieces can be prevented from flying away, thereby further improving the yield.

In the aforesaid construction, it is preferable to use, as said pressure-sensitive adhesive sheet, one such that an acid value of the base polymer which is a constituent component of said pressure-sensitive adhesive layer is 1 to 200. By setting the acid value of the aforesaid base polymer to be 1 or more, decrease in the adhesive strength of the pressure-sensitive adhesive layer can be restrained. As a result thereof, when dicing of a semiconductor wafer, for example, is carried out, semiconductor chips made into individual pieces can be prevented from flying away, thereby further improving the yield. On the other hand, by setting the aforesaid acid value to be 200 or less, a high adhesion property can be maintained. Here, the aforesaid acid value means the mg number of potassium hydroxide needed to neutralize the COOH groups contained in 1 g of a sample.

Also, in the aforesaid construction, it is preferable to use, as said pressure-sensitive adhesive sheet, one such that the base polymer which is a constituent component of said pressure-sensitive adhesive layer has a carboxyl group. When a polymer containing a carboxyl group is used as the base polymer, the adhesive strength of the pressure-sensitive adhesive layer can be improved. As a result thereof, when dicing of a semiconductor wafer, for example, is carried out, semiconductor chips made into individual pieces can be prevented from flying away, thereby further improving the yield.

In the aforesaid construction, it is preferable to use, as said pressure-sensitive adhesive sheet, one such that a constituent component of said pressure-sensitive adhesive layer is a radiation-polymerizable oligomer.

Further, in the aforesaid construction, it is preferable to use, as said pressure-sensitive adhesive sheet, one such that said separator is a polyolefin film or a polyester film.

Also, in order to solve the aforementioned problems, a pressure-sensitive adhesive sheet according to the

present invention is characterized by being used in the method of producing an electronic component described above.

## EFFECT OF THE INVENTION

In the present invention, an electronic component is produced by using a pressure-sensitive adhesive sheet provided with a pressure-sensitive adhesive layer in which a half-value period of the electrification charge generated on the surface thereof is 900 seconds or less by the charge decay measuring method based on JIS L1094. When the aforesaid half-value period of the generated electrification charge is 900 seconds or less, charge elimination can be carried out efficiently in a short period of time over the whole surface of the pressure-sensitive adhesive layer upon removing the electrification charge generated on the pressure-sensitive adhesive layer surface after peeling off the separator. This allows that, even when an electronic component such as a semiconductor wafer, for example, is bonded onto the pressure-sensitive adhesive layer, electric discharge to the electronic component is restrained, thereby improving the production yield of the electronic components.

## BRIEF DESCRIPTION OF THE DRAWINGS

Fig. 1 is a schematic view for describing a method of producing an electronic component according to one embodiment of the present invention.
Fig. 2 is a schematic construction view depicting an electric potential measuring section used for measurement of a peeling-off charge voltage in the Examples and others of the present invention.

## MODE FOR CARRYING OUT THE INVENTION

Hereafter, a method of producing an electronic component according to one embodiment of the present invention will be described. Fig. 1 is a descriptive view schematically illustrating a method of producing an electronic component according to the present embodiment.
As shown in Fig. 1(a), the method of producing an electronic component according to the present embodiment uses a pressure-sensitive adhesive sheet 10 in which at least a pressure-sensitive adhesive layer 12 and a separator 13 are sequentially stacked on a base material 11. More specifically, the method at least has a step of peeling the separator 13 off from the pressure-sensitive adhesive layer 12 in said pressure-sensitive adhesive sheet 10, a step of eliminating the electrification charge generated on the surface of said pressure-sensitive adhesive layer 12, and a step of bonding an electronic component 14 onto said pressure-sensitive adhesive layer 12 after charge elimination.
The electronic component in the production method is not particularly limited, and a conventionally known one can be used. Specific examples of the electronic component include semiconductors or semiconductor wafers made of silicon, gallium-arsenic, germanium, gallium nitride, or the like as a constituent material, semiconductor packages into which this is integrated and enclosed, substrates made of ruby, glass, ceramics, or the like as a constituent material, and the like. In the following, the present embodiment will be described by exemplifying a semiconductor wafer as an example of the electronic component; however, it is not intended that the electronic component is limited to a semiconductor wafer.
First, the separator 13 is peeled off from the pressure-sensitive adhesive layer 12 of the pressure-sensitive adhesive sheet 10. At this moment, electrification charge is generated on the surface of the pressure-sensitive adhesive layer 12 and on the separator 13. A method of peeling off is not particularly limited. However, it is preferable to peel the separator 13 off by setting the peeling speed to be small because, when the separator 13 is peeled off by increasing the peeling speed, the electrification charge generated on each of the pressure-sensitive adhesive layer 12 and the separator 13 increases in amount. A peeling-off condition may be specifically such that the peeling-off is preferably carried out, for example, at a temperature of 25°C, a relative humidity of 55%, a peeling speed of 100 mm/min to 5000 mm/min, and a peeling angle of 180°.
Next, the electrification charge generated on the surface of the pressure-sensitive adhesive layer 12 is eliminated. A method of charge elimination is not particularly limited, and, for example, an charge eliminator of self-discharging type; an charge eliminator of electric type such as an charge eliminator of alternating-current type, an charge eliminator of direct-current type, an charge eliminator of blower type, an electrostatic eliminating apparatus using compressed air, or an electrostatic eliminating apparatus using corona discharge; an electrostatic eliminating apparatus of ultraviolet ray or soft X-ray type, or the like can be used. The charge voltage on the surface of the pressure-sensitive adhesive layer 12 after charge elimination is preferably 200 V or less, more preferably 100 V or less, still more preferably 50 V or less.
Here, the present embodiment uses, as said pressure-sensitive adhesive sheet 10, one such that a half-value period of the electrification charge generated on the surface of said pressure-sensitive adhesive layer 12 is 900 seconds

or less, preferably from 0.01 second to 600 seconds, more preferably from 0.01 second to 300 seconds. When the half-value period of the generated electrification charge is larger than 900 seconds, charge elimination on the surface of the pressure-sensitive adhesive layer 12 may become insufficient in some cases. As a result thereof, electric discharge may be generated to said semiconductor wafer 14 when the semiconductor wafer 14 is bonded onto the pressure-sensitive adhesive layer 12, whereby the circuit formed on the surface of the semiconductor wafer 14 may be destroyed and fail to operate normally. Here, the aforesaid half-value period of the generated electrification charge is a value determined by the charge decay measuring method based on JIS L1094. For example, the half-value period can be measured under an environment with an applied voltage of 10 V, a measurement time of 900 seconds, a temperature of 20°C, and a relative humidity of 40% Rh using a static honest meter (type number: H-0110 manufactured by Shishido Electrostatic, Ltd.).

Subsequently, the semiconductor wafer 14 is bonded onto the pressure-sensitive adhesive layer 12 after charge elimination (See Fig. 1(d)). The bonding is carried out, for example, by press-bonding the semiconductor wafer 14 onto the pressure-sensitive adhesive layer 12, followed by adhering and holding it to be fixed. The present step is carried out by pressing with pressing means such as a press-bonding roller. The bonding temperature at the time of the bonding is not particularly limited and is preferably within a range of 20°C to 80°C, for example.

Next, in the present embodiment, dicing can be carried out on the semiconductor wafer 14 bonded on the pressure-sensitive adhesive layer 12. By this dicing, the semiconductor wafer 14 is cut into a predetermined size to be made into individual pieces, so as to produce semiconductor chips 15. The dicing is carried out, for example, from the circuit surface side of the semiconductor wafer 14. A dicing apparatus used in the dicing step is not particularly limited, and a conventionally known one can be used. Also, when ionic liquid described later is added into the pressure-sensitive adhesive layer 12, decrease in the adhesive strength can be prevented because bleeding of the ionic liquid onto the surface of the pressure-sensitive adhesive layer 12 is restrained as compared with a surfactant or the like. As a result thereof, the semiconductor wafer 14 adheres to and is fixed to the pressure-sensitive adhesive layer 12 with more certainty, so that chipping and chip fly can be restrained, and also destruction of the semiconductor wafer 14 can be restrained. Here, the dicing condition can be set suitably in accordance with the needs.

In order to peel off the semiconductor chips 15 adhered and fixed to the pressure-sensitive adhesive layer 12, picking-up of the semiconductor chips 15 is carried out. The method of picking up is not particularly limited, and, for example, a method of pushing up individual semiconductor chips 5 up from the base material 11 side of the pressure-sensitive adhesive sheet 10 with use of a needle and picking up the pushed-up semiconductor chips 15 by a picking-up apparatus can be adopted.

Here, when the pressure-sensitive adhesive layer 12 is of radiation-curing type, the picking-up is preferably carried out after irradiating the pressure-sensitive adhesive layer 12. By this, the adhesive strength of the pressure-sensitive adhesive layer 12 to the semiconductor chips 15 is reduced, whereby the peeling-off of the semiconductor chips 15 can be easily carried out. As a result thereof, the semiconductor chips 15 can be picked up without being damaged. The conditions for irradiating, such as the irradiation intensity and the irradiation time, are not particularly limited and may be set suitably in accordance with the needs.

Next, the pressure-sensitive adhesive sheet 10 used in the present embodiment will be described in detail below. The pressure-sensitive adhesive layer 12 according to the present embodiment is not particularly limited as long as it is one such that a half-value period of the electrification charge generated on a surface thereof is 900 seconds or less by the charge decay measuring method based on JIS L1094 as described before.

As a pressure-sensitive adhesive composition which is a constituent component of the pressure-sensitive adhesive layer 12, a composition in which, for example, a diselectrification agent is blended is preferable. The diselectrification agent in the present invention means an agent that imparts electrical conductivity to the pressure-sensitive adhesive layer 12 by being blended into the pressure-sensitive adhesive layer 12, whereby electric discharge is promoted. Also, in the present invention, ionic liquid is preferable as the aforesaid diselectrification agent. This is because ionic liquid is a liquid organic compound and has a good compatibility with a base polymer (details will be described later) in the pressure-sensitive adhesive composition. This can restrain segregation of the ionic liquid on the surface of the pressure-sensitive adhesive layer 12 and can prevent decrease in the adhesive strength. Here, the ionic liquid means a molten salt (ionic compound) exhibiting a liquid form at room temperature (25°C). Also, compatibility means a property such that, when ionic liquid and a base polymer are mixed by a suitable mixing method (melt blend, solution blend), the two are uniformly mixed and hardly undergo phase separation.

As the ionic liquid, a nitrogen-containing onium salt, a sulfur-containing onium salt or a phosphorus-containing onium salt is preferably used. In particular, since excellent antistatic ability is obtained, an ionic liquid comprising an organic cation component represented by the following general formulas (A) to (D), and an anion component is preferably used.

[Chemical formula 1]

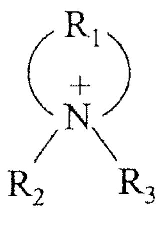

(A)

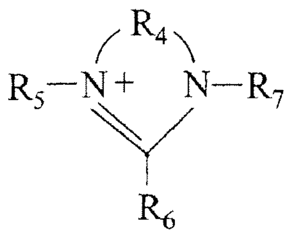

(B)

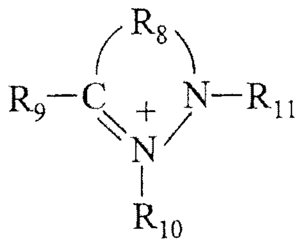

(C)

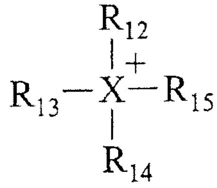

(D)

[in the formula (A), $R_1$ represents a hydrocarbon group of a carbon number of 4 to 20, and may contain a hetero atom, and $R_2$ and $R_3$ are the same or different, represent hydrogen or a hydrocarbon group of a carbon number of 1 to 16, and may contain a hetero atom, provided that, when a nitrogen atom contains a double bond, $R_3$ is not present]

[in the formula (B), $R_4$ represents a hydrocarbon group of a carbon number of 2 to 20, and may contain a hetero atom, and $R_5$, $R_6$ and $R_7$ are the same or different, represent hydrogen or a hydrocarbon group of a carbon number of 1 to 16, and may contain a hetero atom]

[in the formula (C), $R_8$ represents a hydrocarbon group of a carbon number of 2 to 20, and may contain a hetero atom, and $R_9$, $R_{10}$ and $R_{11}$ are the same or different, represent a hydrogen or a hydrocarbon group of a carbon number of 1 to 16, and may contain a hetero atom]

[in the formula (D), X represents a nitrogen atom, a sulfur atom, or a phosphorus atom, and $R_{12}$, $R_{13}$, $R_{14}$ and $R_{15}$ are the same or different, represent a hydrocarbon group of a carbon number of 1 to 20, and may contain a hetero atom, provided that, when X is a sulfur atom, $R_{12}$ is not present]

Examples of the cation represented by the formula (A) include a pyridinium cation, a piperidinium cation, a pyrrolidinium cation, a cation having a pyrroline skeleton, and a cation having a pyrrole skeleton. Specific examples include 1-ethylpyridinium cation, a 1-butylpyridinium cation, 1-hexylpyridinium cation, a 1-butyl-3-methylpyridinium cation, a 1-butyl-4-methylpyridinium cation, a 1-hexyl-3-methylpyridinium cation, a 1-butyl-3,4-dimethylpyridinium cation, a 1,1-dimethylpyrrolidinium cation, a 1-ethyl-1-methylpyrrolidinium cation, a 1-methyl-1-propylpyrrolidinium cation, a 2-methyl-1-pyrroline cation, a 1-ethyl-2-phenylindole cation, a 1,2-dimethylindole cation, and a 1-ethylcarbazole cation.

Examples of the cation represented by the formula (B) include an imidazolium cation, a tetrahydropyrimidinium cation, and a dihydropyrimidinium cation. Specific examples include a 1,3-dimethylimidazolium cation, a 1,3-diethylimidazolium cation, a 1-ethyl-3-methylimidazolium cation, a 1-butyl-3-methyimidazolium cation, a 1-hexyl-3-methylimidazolium cation, 1-ocytl-3-methylimidazolium cation, a 1-decyl-3-methylimidazolium cation, a 1-dodecyl-3-methylimidazolium cation, a 1-tetradecyl-3-methylimidazolium cation, a 1,2-dimethyl-3-propylimidazolium cation, a 1-ethyl-2,3-dimethylimidazolium cation, a 1-butyl-2,3-dimethylimidazolium cation, a 1-hexyl-2,3-dimethylimidazolium cation, a 1,3-dimethyl-1,4,5,6-tetrahydropyrimidinium cation, a 1,2,3-trimethyl-1,4,5,6-tetrahydropyrimidinium cation, a 1,2,3,4-tetramethyl-1,4,5,6-tetrahydropyrimidinium cation, a 1,2,3,5-tetramethyl-1,4,5,6-tetrahydropyrimidinium cation, a 1,3-dimethyl-1,4-dihydropyrimidinium cation, a 1,3-dimethyl-1,6-dihydropyrimidinium cation, a 1,2,3-trimethyl-1,4-dihydropyrimidinium cation, a 1,2,3-trimethyl-1,6-dihydropyrimidinium cation, a 1,2,3,4-tetramethyl-1,4-dihydropyrimidinium cation, and a 1,2,3,4-tetramethyl-1,6-dihydropyrimidinium cation.

Examples of the cation represented by the formula (C) include a pyrazolium cation, and a pyrazolinium cation. Specific examples include a 1-methylpyrazolium cation, a 3-methylpyrazolium cation, and a 1-ethyl-2-methylpyrazolinium cation.

Examples of the cation represented by the formula (D) include a tetraalkylammonium cation, a trialkylsulfonium cation, a tetraalkylphosphonium cation, and those cations in which a part of the alkyl group is substituted with an alkenyl group.

Specific examples include a tetramethylammonium cation, a tetraethylammonium cation, a tetrabutylammonium cation, a tetrahexylammonium cation, a triethylmethylammonium cation, a tributylethylammonium cation, a trimethyldecylammonium cation, a N, N-diethyl-N-methyl-N-(2-methoxyethyl)ammonium cation, a glycidiyltrimethylammonium cation, a N, N-dimethyl-N, N-dipropylammonium cation, a N, N-dimethyl-N, N-dihexylammonium cation, a N, N-dipropyl-N, N-dihexylammonium cation, a trimethylsulfonium cation, a triethylsulfonium cation, a tributylsulfonium cation, a trihexylsulfonium cation, a diethylmethylsulfonium cation, a dibutylethylsulfonium cation, a dimethyldecylsulfonium cation, a tetramethylphosphonium cation, a tetraethylphosphonium cation, a tetrabutylphosphonium cation, a tetrahexylphosphonium cation, a triethylmethylphosphonium cation, a tributylethylphosphonium cation, a trimethyldecylphosphonium cation, and a diallyldimethylammonium cation.

Inter alia, an asymmetric tetraalkylammonium cation such as a triethylmethylammonium cation, a tributylethylammonium cation, a trimethyldecylammonium cation, a N, N-diethyl-N-methyl-N-(2-methoxyethyl)ammonium cation, a glycidyltrimethylammonium cation, a N, N-dimethyl-N-ethyl-N-propylammonium cation, a N, N-dimethyl-N-ethyl-N-butylammonium cation, a N, N-dimethyl-N-ethyl-N-pentylammonium cation, a N, N-dimethyl-N-ethyl-N-hexylammonium cation, a N, N-dimethyl-N-ethyl-N-heptylammonium cation, a N, N-dimethyl-N-ethyl-N-nonylammonium cation, a N, N-dimethyl-N-propyl-N-butylammonium cation, a N, N-dimethyl-N-propyl-N-pentylammonium cation, a N, N-dimethyl-N-propyl-N-hexylammonium cation, a N, N-dimethyl-N-propyl-N-heptylammonium cation, a N, N-dimethyl-N-butyl-N-hexylammonium cation, a N, N-dimethyl-N-butyl-N-heptylammonium cation, a N, N-dimethyl-N-pentyl-N-hexylamonium cation, a trimethylheptylammonium cation, a N, N-diethyl-N-methyl-N-propylammonium cation, a N, N-diethyl-N-methyl-N-pentylammonium cation, a N, N-diethyl-N-methyl-N-heptylammonium cation, a N, N-diethyl-N-propyl-N-pentylammonium cation, a triethylmethylammonium cation, a triethylpropylammonium cation, a triethylpentylammonium cation, a triethylheptylammonium cation, a N, N-dipropyl-N-methyl-N-ethylammonium cation, a N, N-dipropyl-N-methyl-N-pentylammonium cation, a N, N-dipropyl-N-butyl-N-hexylammonium cation, a N, N-dibutyl-N-methyl-N-pentylammonium cation, a N, N-dibutyl-N-methyl-N-hexylammonium cation, a trioctylmethylammonium cation, a N, methyl-N-ethyl-N-propyl-N-pentylammonium cation, a trialkylsulfonium cation such as a diethylmethylsulfonium cation, a dibutylethylsulfonium cation, and a dimethyldecylsulfonium cation, an asymmetric tetraalkylphosphonium cation such as a triethylmethylphosphonium cation, a tributylethylphosphonium cation, and a trimethyldecylphophonium cation are preferably used.

On the other hand, the anionic component is not particularly limited as far as it satisfies that it becomes an ionic liquid. Specifically, for example, $Cl^-$, $Br^-$, $I^-$, $AlCl_4^-$, $Al_2Cl_7^-$, $BF_4^-$, $PF_6^-$, $ClO_4^-$, $NO_3^-$, $CH_3COO^-$, $CF_3COO^-$, $CH_3SO_3^-$, $CF_3SO_3^-$, $(CF_3SO_2)_2N^-$, $(CF_3SO_2)_3C^-$, $AsF_6^-$, $SbF_6^-$, $NbF_6^-$, $TaF_6^-$, $F(HF)n^-$, $(CN)_2N^-$, $C_4F_9SO_3^-$, $(C_2F_5SO_2)_2N^-$, $C_3F_7COO^-$, and $(CF_3SO_2)$ $(CF_3CO)N^-$ are used. Among them, in particular, an anionic component containing a fluorine atom is preferably used because a low melting point ionic compound is obtained.

An embodiment of an ionic liquid used in the present invention is used by appropriately selecting from a combination of the aforementioned cation component and anion component. Examples include 1-butylpyridinium tetrafluoroborate, 1-butylpyridinium hexafluorophosphate, 1-butyl-3-methylpyridinium tetrafluoroborate, 1-butyl-3-methylpyridinium trifluoromethanesulfonate, 1-butyl-3-methylpyridinium bis(trifluoromethaneslufonyl)imide, 1-butyl-3-methylpyridinium bis(pentafluoroethanesulfonyl)imide, 1-hexylpyridinium tetrafluoroborate, 2-methyl-1-pyrroline tetrafluoroborate, 1-ethyl-2-phenylindole tetrafluoroborate, 1,2-dimethylindole tetrafluoroborate, 1-ethylcarbazole tetrafluoroborate, 1-ethyl-3-methylimidazolium tetrafluoroborate, 1-ethyl-3-methylimidazolium acetate, 1-ethyl-3-methylimidazolium trifluoroacetate, 1-ethyl-3-methylimidazolium heptafluorobutyrate, 1-ethyl-3-methylimidazolium trifluoromethanesulfonate, 1-ethyl-3-methylimidazolium perfluorobutanesulfonate, 1-ethyl-3-methylimidazolium dicyanamide, 1-ethyl-3-methylimidazolium bis(trifluoromethanesulfonyl)imide, 1-ethyl-3-methylimidazolium bis(pentafluoroethanesulfonylimide), 1-ethyl-3-methylimidazolium tris(trifluoromethanesulfonyl)imide, 1-butyl-3-methylimidazolium tetrafluoroborate, 1-butyl-3-methylimidazolium hexafluorophosphate, 1-butyl-3-methylimidazolium trifluoroacetate, 1-butyl-3-methylimidazolium heptafluorobutyrate, 1-butyl-3-methylimidazolium trifluoromethanesulfonate, 1-butyl-3-methylimidazolium pentafluorobutanesulfonate, 1-butyl-3-methylimidazolium bis(trifluoromethanesulfonyl)imide, 1-hexyl-3-methylimidazolium bromide, 1-hexyl-3-methylimidazolium chloride, 1-hexyl-3-methylimidazolium tetrafluoroborate, 1-hexyl-3-methylimidazolium hexafluorophosphate, 1-hexyl-3-methylimidazolium trifluoromethanesulfonate, 1-octyl-3-methylimidazolium tetrafluoroborate, 1-octyl-3-methylimidazolium hexafluorophosphate, 1-hexyl-2,3-dimethylimidazolium tetrafluoroborate, 1,2-dimethyl-3-propylimidazolium bis(trifluoromethanesulfonyl)imide, 1-methylpyrazolium tetrafluoroborate, 3-methylpyrazolium tetrafluoroborate, tetrahexylammonium bis(trifluoromethanesulfonyl)imide, diallyldimethylammonium tetrafluoroborate, diallyldimethylammonium trifluoromethanesulfonate, diallyldimethylammoniumbis(trifluoromethanesulfonyl)imide, diallyldimethylammonium bis(pentafluoroethanesulfonyl)imide, 1-butylpyridinium (trifluoromethanesulfonyl)trifluoroacetamide, 1-butyl-3-methylpyridinium (trifluoromethanesulfonyl)trifluoroacetamide, 1-ethyl-3-methylimidazolium (trifluoromethanesulfonyl)trifluoroacetamide, diallyldimethylammonium (trifluoromethanesulfonyl)trifluoroacetamide, N, N-dimethyl-N-ethyl-N-propylammonium
bis(trifluoromethanesulfonyl)imide, N, N-dimethyl-N-ethyl-N-butylammonium bis(trifluoromethanesulfonyl)imide, N, N-dimethyl-N-ethyl-N-pentylammonium
bis(trifluoromethanesulfonyl)imide, N, N-dimethyl-N-ethyl-N-hexylammonium bis(trifluoromethanesulfonyl)imide, N, N-dimethyl-N-ethyl-N-heptylammonium
bis(trifluoromethanesulfonyl)imide, N, N-dimethyl-N-ethyl-N-nonylamonium bis(trifluoromethanesulfonyl)imide, N, N-dimethyl-N, N-dipropylammonium
bis(trifluoromethanesulfonyl)imide, N, N-dimethyl-N-propyl-N-butylammonium bis(trifluoromethanesulfonyl)imide, N, N-dimethyl-N-propyl-N-pentylammonium
bis(trifluoromethanesulfonyl)imide, N, N-dimethyl-N-propyl-N-hexylammonium bis(trifluoromethanesulfonyl)imide, N, N-dimethyl-N-propyl-N-heptylammonium
bis(trifluoromethanesulfonyl)imide, N, N-dimethyl-N-butyl-N-hexylammonium bis(trifluoromethanesulfonyl)imide, N, N-dimethyl-N-butyl-N-heptylammonium

bis(trifluoromethanesulfonyl)imide, N, N-dimethyl-N-pentyl-N-hexylammonium bis(trifluoromethanesulfonyl)imide, N, N-dimethyl-N, N-dihexylammonium bis(trifluoromethanesulfonyl)imide, trimethylheptylammonium bis(trifluoromethanesulfonyl)imide, N, N-diethyl-N-methyl-N-propylammonium bis(trifluoromethanesulfonyl)imide, N, N-diethyl-N-methyl-N-pentylammonium bis(trifluoromethanesulfonyl)imide, N, N-diethyl-N-methyl-N-heptylammonium bis(trifluoromethanesulfonyl)imide, N, N-diethyl-N-propyl-N-pentylammonium bis(trifluoromethanesulfonyl)imide, triethylpropylammonium bis(trifluoromethanesulfonyl)imide, triethylpentylammonium bis(trifluoromethanesulfonyl)imide, triethylheptylammonium bis(trifluoromethanesulfonyl)imide, N, N-dipropyl-N-methyl-N-ethylammonium bis(trifluoromethanesulfonyl)imide, N, N-dipropyl-N-methyl-N-pentylammonium bis(trifluoromethanesulfonyl)imide, N, N-dipropyl-N-butyl-N-hexylammonium bis(trifluoromethanesulfonyl)imide, N, N-dipropyl-N, N-dihexylammonium bis(trifluoromethanesulfonyl)imide, N, N-dibutyl-N-methyl-N-pentylammonium bis(trifluoromethanesulfonyl)imide, N, N-dibutyl-N-methyl-N-hexylammonium bis(trifluoromethanesulfonyl)imide, trioctylmethylammonium bis(trifluoromethanesulfonyl)imide, and N-methyl-N-ethyl-N-propyl-N-pentylammonium bis(trifluoromethanesulfonyl)imide.

As the aforementioned ionic liquid, a commercially available ionic liquid may be used, or the liquid may be synthesized as described below. A method of synthesizing an ionic liquid is not particularly limited as far as an objective ionic liquid is obtained. Generally, a halide method, a hydroxide method, an acid ester method, a chelate forming method, and a neutralization method described in the publication "Ionic liquid-The Front and Future of Development-" (published by CMC) are used.

Regarding a halide method, a hydroxide method, an acid ester method, a chelate forming method, and a neutralization method, a synthesis method using an example of a nitrogen-containing onium salt will be shown below, but other ionic liquid such as a sulfur-containing onium salt, and a phosphorus-containing onium salt can be obtained by the similar procedure.

The halide method is a method which is performed by a reaction shown in the following formulas (1) to (3). First, a tertiary amine and alkyl halide are reacted to obtain halide (Reaction Equation (1), as a halogen, chlorine, bromine or iodine is used). The resulting halide is reacted with an acid (HA) having an anion structure ($A^-$) of an objective ionic liquid or a salt (MA, M is a cation forming a salt with an objective anion such as ammonium, lithium, sodium and potassium) of an objective ionic liquid to obtain an objective ionic liquid ($R_4NA$).

[Chemical formula 2]

(1) $R_3N+RX \rightarrow R_4NX$ (X: Cl, Br, I)
(2) $R_4NX+HA \rightarrow R_4NA+HX$
(3) $R_4NX+MA \rightarrow R_4NA+MX$ (M: $NH_4$, Li, Na, K, Ag etc.)

The hydroxide method is a method performed by a reaction shown in (4) to (8). First, a halide ($R_4NX$) is subjected to ion exchange membrane method electrolysis (reaction equation (4)), an OH-type ion exchange resin method (reaction equation (5)) or a reaction with silver oxide ($Ag_2O$) (reaction equation (6)) to obtain a hydroxide ($R_4NOH$) (as a halogen, chlorine, bromine or iodine is used). The resulting hydroxide is subjected to a reaction of reaction equations (7) to (8) as in the aforementioned halide method to obtain an objective ionic liquid ($R_4NH$).

[Chemical formula 3]

(4) $R4NX+H_2O \rightarrow R_4NOH+1/2H_2+1/2X_2$ (X: Cl, Br, I)
(5) $R_4NX+P\text{-}OH \rightarrow R_4NOH+P\text{-}X$ (P-OH: OH-type ion exchange resin)
(6) $R_4NX+1/2Ag_2O+1/2H_2O \rightarrow R_4NOH+AgX$
(7) $R_4NOH+HA \rightarrow R_4NA+HX$
(8) $R_4NOH+MA \rightarrow R_4NA+MX$ (M: $NH_4$ , Li, Na, K, Ag etc.)

The acid ester method is a method performed by a reaction shown in (9) to (11). First, tertiary amine ($R_3N$) is reacted with acid ester to obtain an acid esterified substance (reaction equation (9), as acid ester, ester of an inorganic acid such as sulfuric acid, sulfurous acid, phosphoric acid, phosphorous acid, and carbonic acid, or ester of organic acid such as methanesulfonic acid, methylphosphonic acid and formic acid is used). The resulting acid esterified substance is subjected to a reaction of reaction equations (10) to (11) as in the aforementioned halide method, to obtain an objective ionic liquid ($R_4NA$). Alternatively, as acid ester, methyl trifluoromethane sulfonate, or methyl trifluoroacetate may be used to directly obtain an ionic liquid.

[Chemical formula 4]

(9) $R_3N+ROY \rightarrow R_4NOY$

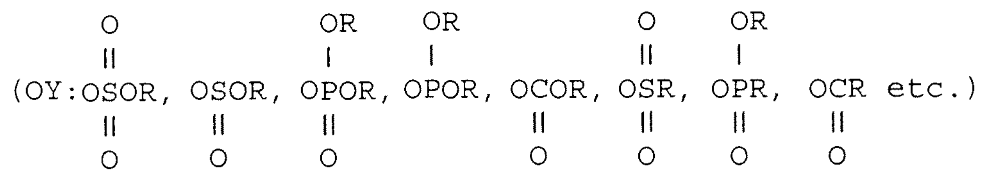

(10) $R_4NOY+HA \rightarrow R_4NA+HOY$

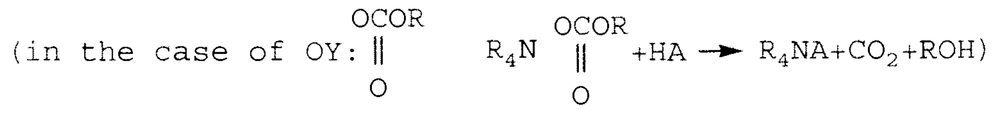

(11) $R_4NOY+MA \rightarrow R_4NA+MOY$ (M: $NH_4$, Li, Na, K, Ag etc.)

The chelate forming method is a method performed by a reaction as shown in (12) to (15). First, halide of quaternary ammonium ($R_4NX$), hydroxide of quaternary ammonium ($R_4NOH$), or carbonic acid esterified substance of quaternary ammonium ($R_4NOCO_2CH_3$) is reacted with hydrogen fluoride (HF) or ammonium fluoride ($NH_4F$) to obtain a quaternary ammonium fluoride salt (reaction equation (12) to (14)). The resulting quaternary ammonium fluoride salt can be subjected to a chelate forming reaction with fluoride such as $BF_3$, $AlF_3$, $PF_5$, $ASF_5$, $SbF_5$, $NbF_5$ and $TaF_6$, to obtain an ionic liquid (reaction equation (15)).

[Chemical formula 5]

(12) $R_4NX+HF \rightarrow R_4NF+HX$ (X: Cl, Br, I)
(13) $R_4NY+HF \rightarrow R_4NF+HY$ (Y: OH, $OCO_2CH_3$)
(14) $R_4NY+NH_4F \rightarrow R_4NF+NH_3+HY$ (Y: OH, $OCO_2CH_3$)
(15) $R_4NF+MF_{n-1} \rightarrow R_4NMF_n$

($MF_{n-1}$: $BF_3$, $AlF_3$, $PF_5$, $ASF_5$, $SbF_5$, $NbF_5$, $TaF_5$ etc.)

The neutralization method is a method performed by a reaction shown in (16). An ionic liquid can be obtained by reacting tertiary amine and an organic acid such as $HBF_4$, $HPF_6$, $CH_3COOH$, $CF_3COOH$, $CF_3SO_3H$, $(CF_3SO_2)_2NH$, $(CF_3SO_2)_3CH$, and $(C_2F_5SO_2)_2NH$.

[Chemical formula 6]

(16) $R_3N+HZ \rightarrow R_3HN^+Z^-$

[HZ: $HBF_4$, $HPF_6$, organic acid such as $CH_3COOH$, $CF_3COOH$, $CF_3SO_3H$, $(CF_3SO_2)_2NH$, $(CF_3SO_2)_3CH$, $(C_2F_5SO_2)_2NH$]

The aforementioned R represents hydrogen or a hydrocarbon group of a carbon number of 1 to 20, and may contain a hetero atom.

Since an amount of an ionic liquid to be blended varies depending on compatibility between a polymer and an ionic liquid to be used, the amount cannot be always indiscriminately defined, but generally is preferably 0.01 to 40 parts by weight, more preferably 0.03 to 20 parts by weight, most preferably 0.05 to 10 parts by weight relative to 100 parts by weight of a base polymer. When the amount is less than 0.01 part by weight, sufficient antistatic property is not obtained and, when the amount exceeds 40 parts by weight, there is a tendency that staining on an adherend is increased.

As the aforesaid base polymer, it is preferable to use a polymer having an acid value of 1 to 200, more preferably 2 to 150, still more preferably 5 to 100. By setting the acid value of the aforesaid base polymer to be 1 or more, decrease in the adhesive strength of the pressure-sensitive adhesive layer 12 can be restrained. On the other hand, by setting the aforesaid acid value to be 200 or less, a high adhesive strength can be maintained. Here, the aforesaid acid value means the mg number of potassium hydroxide needed to neutralize COOH groups contained in 1 g of a sample.

In the present invention, as a base polymer, a polymer having a glass transition temperature Tg of 0°C or lower,

preferably, of -100 to -5°C, and more preferably, of -80 to -10°C, is used. When a glass transition temperature Tg exceeds 0°C, it becomes difficult to obtain a sufficient adhering force even when an ionic liquid is contained.

Examples of such the polymer include polymers which are generally applied as a polymer for a pressure-sensitive adhesive, such as an acryl polymer containing, as a main component, one or two or more kinds of acrylate and/or methacrylate having an alkyl group of a carbon number of 1 to 14, a natural rubber, a styrene-isoprene-styrene block copolymer (SIS block copolymer), a styrene-butadienestyrene block copolymer (SBS block copolymer), a styrene-ethylene·butylene-styrene block copolymer (SEBS block copolymer), a styrene-butadiene rubber, polybutadiene, polyisoprene, polyisobutyrene, a butyl rubber, a chloroprene rubber, and a silicone rubber.

Among them, since balance of compatibility with an ionic liquid and excellent pressure-sensitive adhesive property are obtained, an acryl polymer containing, as a main component, one or two or more kinds of acrylate and/or methacrylate having an alkyl group of a carbon number of 1 to 14 is preferably used.

As an acryl polymer containing, as a main component, one or two or more kinds of acrylate and/or methacrylate having an alkyl group of a carbon number of 1 to 14, an acryl polymer having a weight average molecular weight of 100 thousands or more containing, as a main component, a monomer containing 50 to 100 % by weight of one or two or more kinds of acrylate and/or methacrylate {hereinafter, (meth)acrylate refers to as acrylate and/or methacrylate} having an alkyl group having a carbon number of 1 to 14 is used.

Examples of (meth)acrylate having an alkyl group of a carbon number of 1 to 14 include methyl (meth)acrylate, ethyl (meth)acrylate, n-butyl (meth)acrylate, t-butyl (meth)acrylate, isobutyl (meth)acrylate, hexyl (meth)acrylate, 2-ethylhexyl (meth)acrylate, n-octyl (meth)acrylate, isooctyl (meth)acrylate, n-nonyl (meth)acrylate, isononyl (meth)acrylate, n-decyl (meth)acrylate, isodecyl (meth)acrylate, n-dodecyl (meth)acrylate, n-tridecyl (meth)acrylate, and n-tetradecyl (meth)acrylate. Here, (meth)acrylate means acrylate and/or methacrylate, and (meth) in the present invention all means the same.

Further, as the base polymer, a polymer having a high polarity (hydrophilicity) is preferable. By using a polymer having a high polarity, compatibility with the diselectrification agent will be improved, whereby segregation of the diselectrification agent onto the surface of the pressure-sensitive adhesive layer 12 can be prevented, and decrease in the adhesive strength can be restrained. As the base polymer having a high polarity, a polymer containing 0.1 part by weight or more, preferably 0.1 part by weight to 30 parts by weight, more preferably 0.1 part by weight to 20 parts by weight, of a monomer having a high polarity relative to 100 parts by weight of a main monomer (for example, an acryl polymer containing one kind or two or more kinds of acrylate and/or methacrylate having an alkyl group with a carbon number of 1 to 14 as a major component, or the like) is preferable. As the aforesaid monomer having a high polarity, an acrylic acid or the like can be mentioned as an example. Here, having a high polarity in the present invention means a case of having a dielectric constant of 2.0 or more.

As other components, from viewpoints of balance of pressure-sensitive adhesive performance and a glass transition point Tg of 0°C or lower (usually -100°C or higher), a cohesive strength or a heat resistance improving component such as a sulfonic acid group-containing monomer, a phosphoric acid group-containing monomer, a cyano group-containing monomer, vinyl esters, and an aromatic vinyl compound, and a component having a functional group working for improving an adhering force or for a crosslinking point, such as a carboxyl group-containing monomer, an acid anhydride group-containing monomer, a hydroxyl group-containing monomer, an amido group-containing monomer, an amino group-containing monomer, an epoxy group-containing monomer, N-acryloylmorpholine, vinyl ethers can be appropriately used. Other components may be used alone, or two or more of them may be used jointly.

When acrylate and/or methacrylate having an acid functional group such as a carboxyl group, a sulfonic acid group and a phosphoric acid group is used, it is preferable to adjust an acid value of an acryl polymer 29 or less. When an acid value of an acryl polymer exceeds 29, there is a tendency that antistatic property is deteriorated. An acid value can be adjusted by an amount of acrylate and/or methacrylate having an acid functional group to be blended, and examples thereof include an acryl polymer obtained by copolymerizing 2-ethylhexyl acrylate and acrylic acid as an acryl polymer having a carboxyl group. In this case, by adjusting acrylic acid at 3.7 parts by weight relative to a total of 100 parts by weight of 2-ethylhexyl acrylate and acrylic acid, the aforementioned acid value can be satisfied.

Examples of the sulfonic acid group-containing monomer include styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid. Examples of the phosphoric acid group-containing monomer include 2-hydroxyethylacryloyl phosphate.

Examples of the cyano group-containing monomer include acrylonitrile. Examples of vinylesters include vinyl acetate.

Examples of the aromatic vinyl compound include styrene. Examples of the carboxyl group-containing monomer include (meth)acrylic acid, carboxyethyl (meth)acrylate, carboxypentyl (meth)acrylate, itaconic acid, maleic acid, fumaric acid, and crotonic acid. Examples of the acid anhydride group-containing monomer include maleic acid anhydride, and itaconic acid anhydride.

Examples of the hydroxyl group-containing monomer include 2-hydroxyethyl (meth)acrylate, 2-hydroxypropyl

(meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, (4-hydroxymethylcyclohexyl)methyl acrylate, N-methylol (meth)acrylamide, vinyl alcohol, allyl alcohol, 2-hydroxyethyl vinyl ether, 4-hydroxybutylvinyl ether, and diethylene glycol monovinyl ether.

Examples of the amido group-containing monomer include acrylamide, diethylacrylamide. Examples of the amino group-containing monomer include N, N-dimethylaminoethyl (meth)acrylate, and N, N-dimethylaminopropyl (meth) acrylate. Examples of the epoxy group-containing monomer include glycidyl (meth)acrylate, and allyl glycidyl ether.

Examples of vinyl ethers include methyl vinyl ether. The acryl polymer of the present embodiment is obtained by a polymerization method which is generally used as a procedure for synthesizing an acryl polymer such as solution polymerization, emulsion polymerization, bulk polymerization and suspension polymerization.

In the pressure-sensitive adhesive composition of the present embodiment, pressure-sensitive adhesive sheets further excellent in heat resistance are obtained by appropriately crosslinking a base polymer, in particular, an acryl polymer. Examples of a specific means for a crosslinking method include a so-called method of using a crosslinking agent, in which a compound, such as an polyisocyanate compound, an epoxy compound and an aziridine compound, having a group reactive with a carboxyl group, a hydroxyl group, an amino group or an amido group which is appropriately contained as a crosslinking basal point in an acryl polymer is added to react them. Inter alia, a polyisocyanate compound and an epoxy compound are particularly preferably used.

Examples of the polyisocyanate compound include lower aliphatic polyisocyanates such as butylene diisocyanate, and hexamethylene diisocyanate, alicyclic isocyanates such as cyclopentylene diisocyanate, cyclohexylene diisocyanate, and isophorone diisocyanate, aromatic diisocyanates such as 2,4-tolylene diisocyanate, 4,4'-diphenylmethane diisocyanate, and xylene diisocyanate, and isocyanate adducts such as trimethylolpropane/tolylene diisocyanate trimer adduct (trade name: Coronate L manufactured by Nippon Polyurethane Industry Co., Ltd.), trimethylolpropane/hexamethylene diisocyanate trimer adduct (trade name: Coronate HL manufactured by Nippon Polyurethane Industry Co., Ltd.), and isocyanurate of hexamethylene diisocyanate (trade name: Coronate HX manufactured by Nippon Polyurethane Industry Co., Ltd.). Examples of the epoxy compound include N,N,N',N'-tetraglycidyl-m-xylenediamine (trade name TETRAD-X manufactured by Mitsubishi Gas Chemical Company, Inc.) and 1,3-bis(N,N-diglycidylaminomethyl) cyclohexane (trade name TETRAD-C manufactured by Mitsubishi Gas Chemical Company Inc.). These crosslinking agents may be used alone, or may be used by mixing two or more kinds. An amount of these crosslinking agents to be used depends on balance between an acryl polymer to be crosslinked, and is appropriately selected depending on utility as a pressure-sensitive adhesive sheet.

In order to obtain sufficient heat resistance due to a cohesive strength of an acryl pressure-sensitive adhesive, generally, a content of the polyisocyanate compound is preferably 0.5 parts by weight or more relative to 100 parts by weight of the acryl polymer. From viewpoints of flexibility and adhesive property, a content of the polyisocyanate compound is preferably 10 parts by weight or less relative to 100 parts by weight of the acryl polymer.

Alternatively, a polyfunctional monomer containing two or more radiation-reactive unsaturated bonds or a radiation polymerizable oligomer is added as a substantial crosslinking agent, and this may be crosslinked with radiation.

As the polyfunctional monomer having two or more radiation-reactive unsaturated bonds, a polyfunctional monomer component having two or more of one kind or two or more kinds radiation-reactive groups which can be crosslinking-treated (cured) by irradiation of radiation, such as a vinyl group, an acryloyl group, a methacryloyl group, and a vinylbenzyl group is used. Generally, a component having 10 or less of radiation-reactive unsaturated bonds is suitably used. Two or more kinds of the polyfunctional monomer may be used jointly.

Examples of the polyfunctinal monomer include ethylene glycol di(meth)acrylate, diethlene glycol di(meth) acrylate, tetraethylene glycol di(meth)acrylate, neopentyl glycol di(meth)acrylate, 1,6hexanediol di(meth)acrylate, trimethylolpropane tri(meth)acrylate, pentaerythritol tri(meth)acrylate, dipentaerythritol hexa(meth)acrylate, divinylbenzene, and N,N'-methylenebisacrylamide.

Examples of the radiation polymerizable oligomer component include various oligomers such as urethane based oligomer, polyether based oligomer, polyester based oligomer, polycarbonate based oligomer, and polybutadiene based oligomer. Further, a weight average molecular weight of the oligomer component is preferably about 100 to about 30000.

An amount of the polyfunctinoal monomer or the radiation polymerizable oligomer to be used depends on balance between an acryl polymer to be crosslinked, and is appropriately selected depending on utility as a pressure-sensitive adhesive sheet. In order to obtain sufficient heat resistance due to a cohesive strength of an acryl pressure-sensitive adhesive, generally, the monomer is preferably blended at 0.1 to 30 parts by weight relative to 100 parts by weight of an acryl polymer. From a viewpoint of flexibility and tackiness, the monomer is preferably blended at 10 parts by weight or less relative to 100 parts by weight of an acryl polymer.

Examples of radiation include ultraviolet ray, laser ray, $\alpha$ ray, $\beta$ ray, $\gamma$ ray, X-ray, and electron beam. From a viewpoint of controlling property and better handling property and a cost, ultraviolet ray is suitably used. More preferably, ultraviolet ray having a wavelength of 200 to 400nm is used. Ultraviolet ray can be irradiated using an appropriate light

source such as a high pressure mercury lamp, a micro-wave excitation-type lamp, and a chemical lamp. When ultraviolet ray is used as irradiation, a photopolymerization initiator is added to an acryl pressure-sensitive adhesive layer.

The photopolymerization initiator may be substances that generate a radical or cation by irradiating ultraviolet ray having an appropriate wavelength which can trigger its polymerization reaction depending on the kind of a radiation reactive component.

Example of the photoradical polymerization initiator include benzoins such as benzoin, benzoin methyl ether, benzoin ethyl ether, methyl o-benzoylbenzoate-p-benzoin ethyl ether, benzoin isopropyl ether, and $\alpha$-methylbenzoin, acetophenes such as benzylmethylketal, trichloroacetophenone, 2,2-diethoxyacetophenone, and 1-hydroxycyclohexyl phenyl ketone, propiophenones such as 2-hydroxy-2-methylpropiophenone, and 2-hydroxy-4'-isopropyl-2-methylpropiophenone, benzophenones such as benzophenone, methylbenzophenone, p-chlorobenzophenone, and p-dimethylaminobenzophenone, thioxanthons such as 2-chlorothioxanthon, 2-ethylthioxanthon, and 2-isopropylthioxanthon, acylphosphine oxides such as bis(2,4,6-trimethylbenzoyl)-phenylphosphine oxide, 2,4,6-trimethylbenzoyldiphenylphosphine oxide, and (2,4,6-trimethylbenzoyl)-(ethoxy)-phenylphosphine oxide, benzil, dibenzsuberone, and $\alpha$-acyloxime ether.

Examples of a photocation polymerization initiator include onium salts such as an aromatic diazonium salt, an aromatic iodonium salt, and an aromatic sulfonium salt, organometallic complexes such as an ion-allene complex. a titanocene complex, and an aryl silanol-aluminum complex, nitrobenzyl ester, sulfonic acid derivative, phosphoric acid ester, phenolsulfonic acid ester, diazonaphthoquinone, and N-hydroxymidosulfonate. Two or more kinds of the photopolymerization initiators may be used jointly.

It is preferably that the photopolymerization initiator is blended usually in a range of 0.1 to 10 parts by weight, preferably 0.2 to 7 parts by weight relative to 100 parts by weight of an acryl polymer.

Further, it is also possible to use a photopolymerization initiation assistant such as amines. Examples of the photopolymerization initiation assistant include 2-dimethylaminoethyl benzoate, diemethylaminoacetophenone, p-dimethylaminobenzoic acid ethyl ester, and p-dimethylaminobenzoic acid isoamyl ester. Two or more kinds of the photopolymerization initiation assistants may be used. It is preferably that the polymerization initiation assistant is blended at 0.05 to 10 parts by weight, further 0.1 to 7 parts by weight relative to 100 parts by weight an acryl polymer.

Further, the previously known tackifiers, or the previously known various additives such as a leveling agent, an antioxidant, a corrosion preventing agent, a photo stabilizer, an ultraviolet absorbing agent, a polymerization inhibitor, a silane coupling agent, and a powder, a particle, and a foil of inorganic or organic filer, metal powder and pigment may be appropriately added to the pressure-sensitive adhesive composition used in the pressure-sensitive adhesive sheet of the present embodiment depending on utility.

Pressure-sensitive adhesive sheets 10 of the present embondiment are such that the aforementioned pressure-sensitive adhesive layer is coated on one side or both sides of various supports comprising a plastic film such as a polyester film, or a porous material such as a paper and a non-woven fabric at a thickness of usually 3 to 100$\mu$m, preferably around 5 to 50$\mu$m, to form an aspect of a sheet or a tape. In particular, it is preferable to use a plastic substrate as a support in a case of a surface protecting film.

Also, the peeling adhesive strength on the surface of the pressure-sensitive adhesive layer 12 is preferably 2 N/20 mm to 50 N/20 mm, more preferably 3 N/20 mm to 30 N/20 mm, still more preferably 4 N/20 mm to 20 N/20 mm, to the semiconductor wafer. By setting the peeling adhesive strength to be 2 N/20 mm or more, generation of chip fly at the time of dicing the semiconductor wafer, for example, can be prevented. On the other hand, by setting the peeling adhesive strength to be 50 N/20 mm or less, it is possible to prevent the picking-up of the semiconductor chips from becoming difficult. Further, when the pressure-sensitive adhesive layer 12 is of a radiation-curing type, the peeling adhesive strength after the radiation curing is preferably 0.01 N/20 mm to 1 N/20 mm, more preferably 0.01 N/20 mm to 0.8 N/20 mm, still more preferably 0.01 N/20 mm to 0.5 N/20 mm, to the semiconductor wafer. By setting the peeling adhesive strength to be 0.01 N/20 mm or more, holding of the semiconductor chips after the radiation curing can be enabled. On the other hand, by setting the peeling adhesive strength to be 1 N/20 mm or less, it is possible to prevent the picking-up of the semiconductor chips from becoming difficult. Here, each adhesive strength aforesaid is a value obtained when it is measured by performing peeling off at a temperature of 23°C, a pulling speed of 50 mm/min, and a peeling angle of 180°.

The plastic substrate is not particularly limited as far as it can be formed into a sheet or a film, and examples include a polyolefin film such as polyethylene, polypropylene, poly-1-butene, poly-4-methyl-1-pentene, a polybutadiene film, a polymethylpentene film, an ethylene·propylene copolymer, an ethylene·1-butene copolymer, an ethylene·vinyl acetate copolymer, an ethylene·ethyl acrylate copolymer, and an ethylene·vinyl alcohol copolymer, a polyester film such as polyethylene terephthalate, polyethylene naphthalate, and polybutylene terephthalate, a polyacrylate film, a polyurethane film, a polystyrene film, a polyamide film such as nylon 6, nylon, 6,6, and partially aromatic polyamide, a polyvinyl chloride film, a vinyl chloride copolymer film, a polyvinylidene chloride film, and a polycarbonate film. A thickness of the film is usually 5 to 200 $\mu$m, preferably around 10 to 100 $\mu$m.

The plastic substrate may be subjected to releasing, anti-staining or acid treatment with silicone, fluorine, long chain alkyl-based or fatty acid amide-based releasing agent, or a silica powder, easy adhesion treatment such as alkali

treatment, primer treatment, corona treatment, plasma treatment, and ultraviolet ray treatment, or coating-type, kneading-type, or deposition-type antistatic treatment, if necessary. As a coating method in formation of the electrification preventing layer, the known coating method is appropriately used, and examples include roll coating, gravure coating, reverse coating, roll brushing, spray coating, and air knife coating methods.

The aforesaid separator 13 is bonded for the purpose of protecting the surface of the pressure-sensitive adhesive layer 12. As a base material constituting the separator 13, paper or plastic film can be used; however, a plastic film is suitably used in view of being excellent in surface smoothness. More specifically, a polyolefin film such as polyethylene film, polypropylene film, polybutadiene film, or polymethylpentene film; a polyester film such as polyethylene terephthalate film, polybutylene terephthalate film, or polyurethane film; or the like can be mentioned as an example.

The thickness of the aforesaid separator 13 is typically about 5 μm to 200 μm, preferably about 10 μm to 100 μm. The bonding surface of the aforesaid separator 13 to the pressure-sensitive adhesive layer 12 may be suitably subjected to a releasing agent treatment using a silicone-based, fluorine-based, long-chain-alkyl-based, or aliphatic-acid-amide-based releasing agent, silica powder, or the like.

## EXAMPLES

Hereafter, the present invention will be described in detail by using Examples; however, the present invention is not limited to the following Examples as long as they do not go beyond the gist thereof.

(Acryl polymer A)

A mixture of 80 parts by weight of 2-ethylhexyl acrylate, 20 parts by weight of methyl acrylate, 10 parts by weight of acrylic acid, and 0.2 part by weight of benzoyl peroxide was allowed to react at 65°C for 6 hours in a nitrogen stream, so as to obtain a solution (25 wt%) of acryl polymer having Tg = -49°C, a weight-average molecular weight of 1,000,000, and an acid value of 70.

(Acryl polymer B)

A mixture of 100 parts by weight of 2-ethylhexyl acrylate, 4 parts by weight of acrylic acid, and 0.2 part by weight of AIBN (azobisisobutyronitrile) was allowed to react at 65°C for 6 hours in a nitrogen stream, so as to obtain a solution (33 wt%) of acryl polymer having Tg = - 66°C, a weight-average molecular weight of 550,000, and an acid value of 30.

(Acryl polymer C)

A mixture of 100 parts by weight of 2-ethylhexyl acrylate, 4 parts by weight of 2-hydroxyethyl acrylate, and 0.2 part by weight of AIBN (azobisisobutyronitrile) was allowed to react at 65°C for 6 hours in a nitrogen stream, so as to obtain a solution (35 wt%) of acryl polymer having Tg = -68°C, a weight-average molecular weight of 550,000, and an acid value of 0.

(Example 1)

A pressure-sensitive adhesive solution was prepared by adding 0.1 part by weight of 1-butyl-3-methylpyridiniumbis(trifluoromethanesulfonyl)imide (trade name: CIL-312 manufactured by Japan Carlit Co., Ltd.) as an diselectrification agent, 5 parts by weight of a polyisocyanate compound (trade name: "CORONATE L" manufactured by Nippon Polyurethane Industry Co., Ltd.) as a cross-linking agent, 50 parts by weight of an ultraviolet-polymerizable oligomer (trade name: UV1700TL manufactured by Nippon Gohsei Kagaku kogyo Co., Ltd.), and 3 parts by weight of a photopolymerization initiator (trade name: Irgacure 2959 manufactured by Ciba Specialty Chemicals Co., Ltd.) to 100 parts by weight of the aforesaid acryl polymer A.

The pressure-sensitive adhesive solution prepared above was applied onto a polyethylene terephthalate film (having a thickness of 100 μm) and was heated at 140°C for 2 minutes for cross-linking to form a pressure-sensitive adhesive layer having a thickness of 10 μm. Subsequently, MRF38 (having a thickness of 38 μm) manufactured by Mitsubishi Chemistry Polyester Film Co., Ltd. serving as a separator was bonded onto the pressure-sensitive adhesive layer surface. Through this process, a pressure-sensitive adhesive sheet according to the present Example was manufactured.

(Example 2)

In the present Example, a pressure-sensitive adhesive sheet according to the present Example was manufactured in the same manner as in the aforesaid Example 1 except that the amount of blending the diselectrification agent was changed to 1 part by weight.

(Example 3)

In the present Example, a pressure-sensitive adhesive sheet according to the present Example was manufactured in the same manner as in the aforesaid Example 1 except that the amount of blending the diselectrification agent was changed to 10 parts by weight.

(Example 4)

In the present Example, a pressure-sensitive adhesive sheet according to the present Example was manufactured in the same manner as in the aforesaid Example 1 except that the acryl polymer B was used and that the UV oligomer and the photopolymerization initiator were not blended.

(Example 5)

In the present Example, a pressure-sensitive adhesive sheet according to the present Example was manufactured in the same manner as in the aforesaid Example 4 except that the amount of blending the diselectrification agent was changed to 1 part by weight.

(Example 6)

In the present Example, a pressure-sensitive adhesive sheet according to the present Example was manufactured in the same manner as in the aforesaid Example 4 except that the amount of blending the diselectrification agent was changed to 10 parts by weight.

(Example 7)

In the present Example, a pressure-sensitive adhesive sheet according to the present Comparative Example was manufactured in the same manner as in the aforesaid Example 1 except that the acryl polymer C was used and that the UV oligomer and the photopolymerization initiator were not blended.

(Example 8)

In the present Example, a pressure-sensitive adhesive sheet according to the present Comparative Example was manufactured in the same manner as in the aforesaid Example 7 except that the amount of blending the diselectrification agent was changed to 1 part by weight.

(Example 9)

In the present Example, a pressure-sensitive adhesive sheet according to the present Comparative Example was manufactured in the same manner as in the aforesaid Example 7 except that the amount of blending the diselectrification agent was changed to 10 parts by weight.

(Comparative Example 1)

In the present Comparative Example, a pressure-sensitive adhesive sheet according to the present Comparative Example was manufactured in the same manner as in the aforesaid Example 1 except that the diselectrification agent was not blended.

<Measurement of weight average molecular weight>

A weight average molecular weight was measured using a GPC apparatus (HLC-8220GPC manufactured by Tosoh Corporation). A weight average molecular weight was obtained in terms of polystyrene. Measuring conditions

are as follows.

Sample concentration: 0.2wt% (THF solution)
Sample injection amount: 10μl
Eluent: THF
Flow rate: 0.6ml/min
Measuring temperature: 40°C
Column:

Sample column;
TSKguard column SuperHZ-H(1 column)+TSK gel Super HZM-H(2 columns)
Reference column;
TSK gel SuperH-RC(1 column)
Detector: Refractive index detector (RI)

<Measurement of acid value>

An acid value was measured using an automatically titrating apparatus (COM-550 manufactured by HIRANUMA SANGYO Co., Ltd.), and was obtained by the following equation.

$$A=\{(Y-X)\times f\times 5.611\}/M$$

(A; Acid value
Y; Titration amount of sample solution (ml)
X; Titration amount of solution of only 50g of mixed solvent (ml)
f; Factor of titration solution
M; Weight of polymer sample (g))

Measurement conditions are as follows:

Sample solution: About 0.5g of a polymer sample was dissolved in 50g of a mixed solvent (toluene/2-propanol/distilled water= 50/49.5/0.5, weight ratio) to obtain a sample solution.
Titration solution: 0.1N 2-propanolic potassium hydroxide solution (for petroleum product neutralization value test manufactured by Wako Pure Chemical Industries, Ltd.)
Electrode: glass electrode; GE-101, comparative electrode; RE-201, Measurement mode: petroleum product neutralization value test 1

(Half-value period of electrification charge)

The half-value period of an electrification charge generated on the surface of the pressure-sensitive adhesive layer in the pressure-sensitive adhesive sheet manufactured in each of the Examples and Comparative Examples was determined by the charge decay measuring method based on JIS L1094. First, by using a static honest meter (type number: H-0110 manufactured by Shishido Electrostatic, Ltd.), each pressure-sensitive adhesive sheet was fixed onto the table thereof. Next, a voltage was applied onto the pressure-sensitive adhesive sheet surface by corona discharge while rotating the table in the horizontal direction. After the detected value of the electric potential thereof reached a saturation value, the high-voltage application was shut off, and the state of decaying of the electric potential thereafter was observed. The period of time until the value reached half of the saturation value was measured as the half-value period. Here, the measurement condition was set to be a condition with an applied voltage of 10 V, a measurement time of 900 seconds, a temperature of 20°C, and a relative humidity of 40% Rh.

(Peeling adhesive strength)

A sample piece of each pressure-sensitive adhesive sheet was cut out in 20 mm width × 12 cm length in the flow direction. After this was bonded onto a silicon mirror wafer and left to stand for about 30 minutes, the peeling adhesive strength was measured. Regarding the pressure-sensitive adhesive sheet provided with a pressure-sensitive adhesive layer of ultraviolet-curing type, the peeling adhesive strength (N/20 mm) before irradiation of ultraviolet rays was measured. The measurement condition was set to be a condition with a measuring apparatus of Tensilon (manufactured by Orientec Co., Ltd.), a temperature of 23°C, a pulling speed of 50 mm/minute, and a peeling angle of 180°.

(Charge elimination property)

The charge elimination property on the surface after the separator was peeled off was confirmed. Specifically, a double-sided pressure-sensitive adhesive tape having a size of 30 mm × 70 mm was bonded onto an acrylic plate having a size of 70 mm × 70 mm. Thereonto, a base material side of the pressure-sensitive adhesive sheet according to the Examples and Comparative Examples having a size of 30 mm × 70 mm was bonded. Then, the separator was quickly peeled off by hand, and the amount of electrification charge on the pressure-sensitive adhesive layer surface was measured using a potential measuring instrument [KSD-0202 manufactured by Kasuga Denki Co., Ltd.]. Next, an earth line was brought into contact with the pressure-sensitive adhesive layer surface, and the amount of electrification charge on the pressure-sensitive adhesive layer surface was measured again to confirm the change in the amount of electrification charge on the pressure-sensitive adhesive layer. When the amount of electrification charge decreased to half within one minute after disposing the earth line as a result thereof, it was evaluated as "O". When the amount of electrification charge did not decrease to half within one minute, it was evaluated as "×". The results are shown in the following Table 2.

(Adhesion property)

Evaluation of the adhesion property of each pressure-sensitive adhesive sheet to the electronic component was carried out by using a silicon wafer as the electronic component and confirming the phenomenon of chip fly that occurs when this is diced. Specifically, a silicon wafer having a thickness of 200 μm was diced under the following condition, and the presence or absence of the chips that could not be held and flew away at that time due to a low adhesive strength was confirmed. When fly of chips was not seen, it was evaluated as "O". When fly of chips was seen, it was evaluated as "×". The results are shown in the following Table 2.

<Dicing condition>

Silicon wafer: 6 inches and 200 μm
Dicing apparatus: DFD-651 manufactured by DISCO Corporation.
Dicing blade: 27HECC manufactured by DISCO Corporation.
Blade rotation number: 40000 rpm
Dicing speed: 50 mm/sec
Dicing depth: 25 μm
Cut mode: downcut
Dicing size: 5 mm × 5 mm

[Table 1]

| | Kind of acryl polymer | Blend amount of acryl polymer (parts by weight) | Blend amount of diselectrification agent (parts by weight) | Blend amount of cross-linking agent (parts by weight) | Blend amount of UV oligomer (parts by weight) | Blend amount of photopolymerization initiator (parts by weight) |
|---|---|---|---|---|---|---|
| Example 1 | A | 100 | 0.1 | 5 | 50 | 3 |
| Example 2 | A | 100 | 1 | 5 | 50 | 3 |
| Example 3 | A | 100 | 10 | 5 | 50 | 3 |
| Example 4 | B | 100 | 0.1 | 5 | Absent | Absent |
| Example 5 | B | 100 | 1 | 5 | Absent | Absent |
| Example 6 | B | 100 | 10 | 5 | Absent | Absent |

(continued)

| | Kind of acryl polymer | Blend amount of acryl polymer (parts by weight) | Blend amount of diselectrification agent (parts by weight) | Blend amount of cross-linking agent (parts by weight) | Blend amount of UV oligomer (parts by weight) | Blend amount of photopolymerization initiator (parts by weight) |
|---|---|---|---|---|---|---|
| Example 7 | C | 100 | 0.1 | 5 | Absent | Absent |
| Example 8 | C | 100 | 1 | 5 | Absent | Absent |
| Example 9 | C | 100 | 10 | 5 | Absent | Absent |
| Comparative Example 1 | A | 100 | Absent | 5 | 50 | 3 |

[Table 2]

| | Type | Presence or absence of acrylic acid | Presence or absence of diselectrification agent | Peeling adhesive strength (N/20mm) | Half-value period (second) | Charge elimination property | Adhesion property |
|---|---|---|---|---|---|---|---|
| Example 1 | UV-setting pressure-sensitive adhesive | Present | Ionic liquid | 6.53 | 226.0 | ○ | ○ |
| Example 2 | UV-setting pressure-sensitive adhesive | Present | Ionic liquid | 6.83 | 64.4 | ○ | ○ |
| Example 3 | UV-setting pressure-sensitive adhesive | Present | Ionic liquid | 6.48 | 0.9 | ○ | ○ |
| Example 4 | Pressure-sensitive adhesive | Present | Ionic liquid | 3.20 | 350.4 | ○ | ○ |
| Example 5 | Pressure-sensitive adhesive | Present | Ionic liquid | 2.85 | 228.9 | ○ | ○ |
| Example 6 | Pressure-sensitive adhesive | Present | Ionic liquid | 2.18 | 0.5> | ○ | ○ |
| Example 7 | Pressure-sensitive adhesive | Absent | Ionic liquid | 0.21 | 24 | ○ | × |
| Example 8 | Pressure-sensitive adhesive | Absent | Ionic liquid | 0.24 | 10 | ○ | × |
| Example 9 | Pressure-sensitive adhesive | Absent | Ionic liquid | 0.11 | 0.5 | ○ | × |
| Comparative Example 1 | UV-setting pressure-sensitive adhesive | Present | Absent | 12.60 | *900s< | × | ○ |

* Electrification potential after 900 seconds decayed by about 10% relative to initial value

(Results)

As been clear from the results of Table 1 and Table 2 described above, according to the pressure-sensitive adhesive sheets of Examples 1 to 9 of the present invention, the half-value period of the electrification potential on the surface of the pressure-sensitive adhesive layer after the separator had been peeled off was 900 seconds or less, so that the electric potential could be eliminated in an extremely short period of time when charge elimination was carried out. Also, in the pressure-sensitive adhesive sheet according to Examples 1 to 6, it has been confirmed that the decrease in the peeling adhesive strength of the pressure-sensitive adhesive layer also can be prevented by addition of acrylic acid which is a monomer having a high polarity. On the other hand, with regard to the pressure-sensitive adhesive sheet of Comparative Example 1, since ionic liquid serving as a diselectrification agent had not been blended, the half-value period of the electrification potential exceeded 900 seconds, and also high electric potential state was remained even when charge elimination was carried out.

DESCRIPTION OF REFERENCE SIGNS

| | |
|---|---|
| 10 | pressure-sensitive adhesive sheet |
| 11 | base material |
| 12 | pressure-sensitive adhesive layer |
| 13 | separator |
| 14 | semiconductor wafer |
| 15 | semiconductor chip |

**Claims**

1. A method of producing an electronic component using a pressure-sensitive adhesive sheet in which at least a pressure-sensitive adhesive layer and a separator are sequentially stacked on a base material, the pressure-sensitive adhesive sheet having 900 seconds or less of a half-value period of the electrification charge generated on a surface of said pressure-sensitive adhesive layer by the charge decay measuring method based on JIS L1094, at least comprising:

   a step of peeling said separator off from said pressure-sensitive adhesive layer;
   a step of eliminating the electrification charge on the surface of said pressure-sensitive adhesive layer; and
   a step of bonding an electronic component onto said pressure-sensitive adhesive layer after charge elimination.

2. The method of producing an electronic component according to claim 1, that uses, as said pressure-sensitive adhesive sheet, one in which ionic liquid within a range of 0.01 part by weight to 30 parts by weight is added to said pressure-sensitive adhesive layer relative to 100 parts by weight of a base polymer thereof.

3. The method of producing an electronic component according to claim 2, wherein
   the base polymer in said pressure-sensitive adhesive layer of said pressure-sensitive adhesive sheet is at least formed of an acryl polymer formed of at least one of an acrylate having an alkyl group with a carbon number of 1 to 14 and a methacrylate having an alkyl group with a carbon number of 1 to 14, and a monomer having a high polarity, and
   said monomer having a high polarity is blended in an amount of 0.1 part by weight or more relative to 100 parts by weight of said acryl polymer.

4. The method of producing an electronic component according to any one of claims 1 to 3, that uses, as said pressure-sensitive adhesive sheet, one such that an acid value of the base polymer which is a constituent component of said pressure-sensitive adhesive layer is 1 to 200.

5. The method of producing an electronic component according to any one of claims 1 to 4, that uses, as said pressure-sensitive adhesive sheet, one such that the base polymer which is a constituent component of said pressure-sensitive adhesive layer has a carboxyl group.

6. The method of producing an electronic component according to any one of claims 1 to 5, that uses, as said pressure-sensitive adhesive sheet, one such that a constituent component of said pressure-sensitive adhesive layer is a radiation-polymerizable oligomer.

7. The method of producing an electronic component according to any one of claims 1 to 6, that uses, as said pressure-sensitive adhesive sheet, one such that said separator is a polyolefin film or a polyester film.

8. A pressure-sensitive adhesive sheet that is used in a method of producing an electronic component according to any one of claims 1 to 7.

FIG. 1

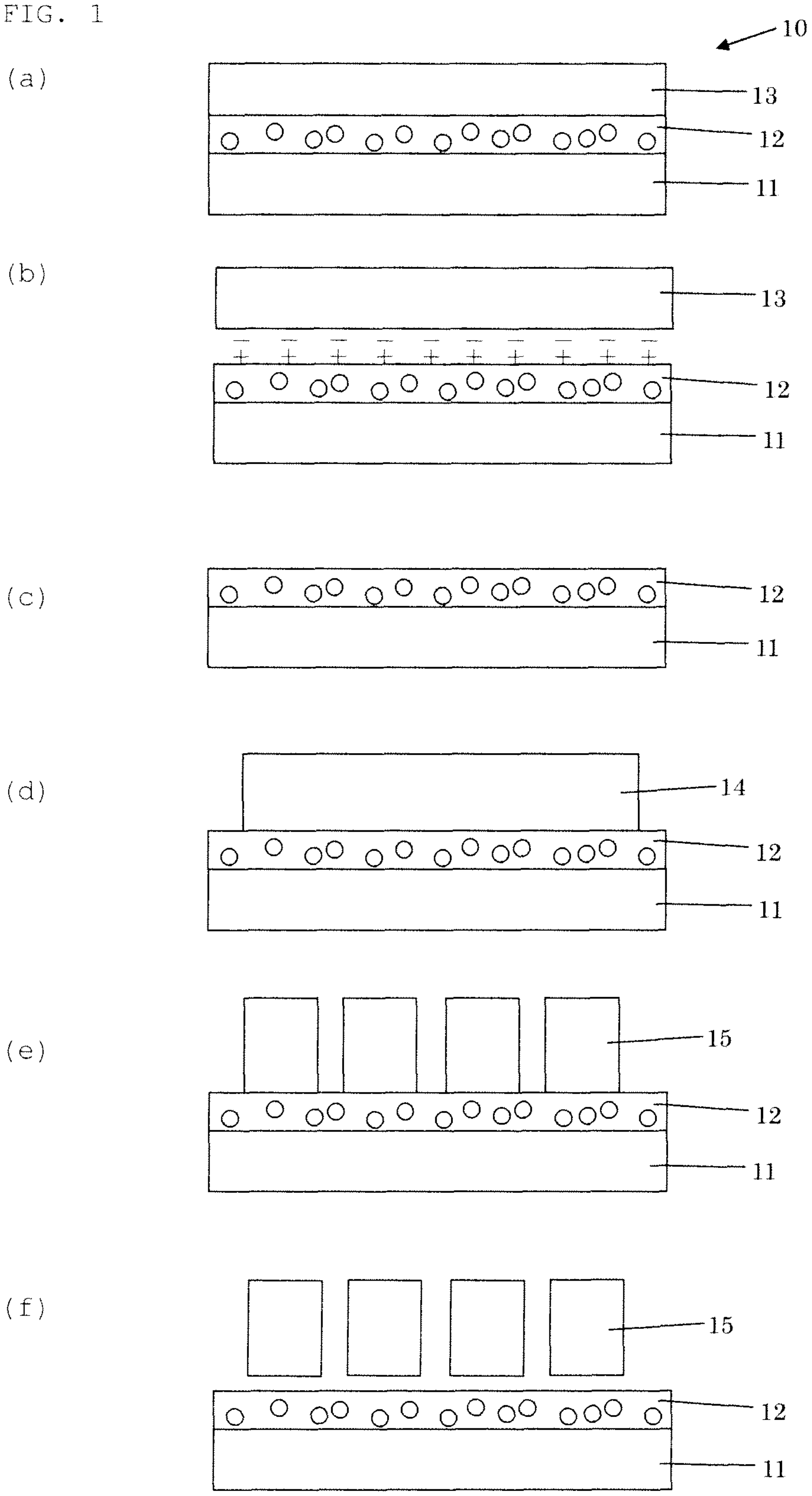

FIG. 2

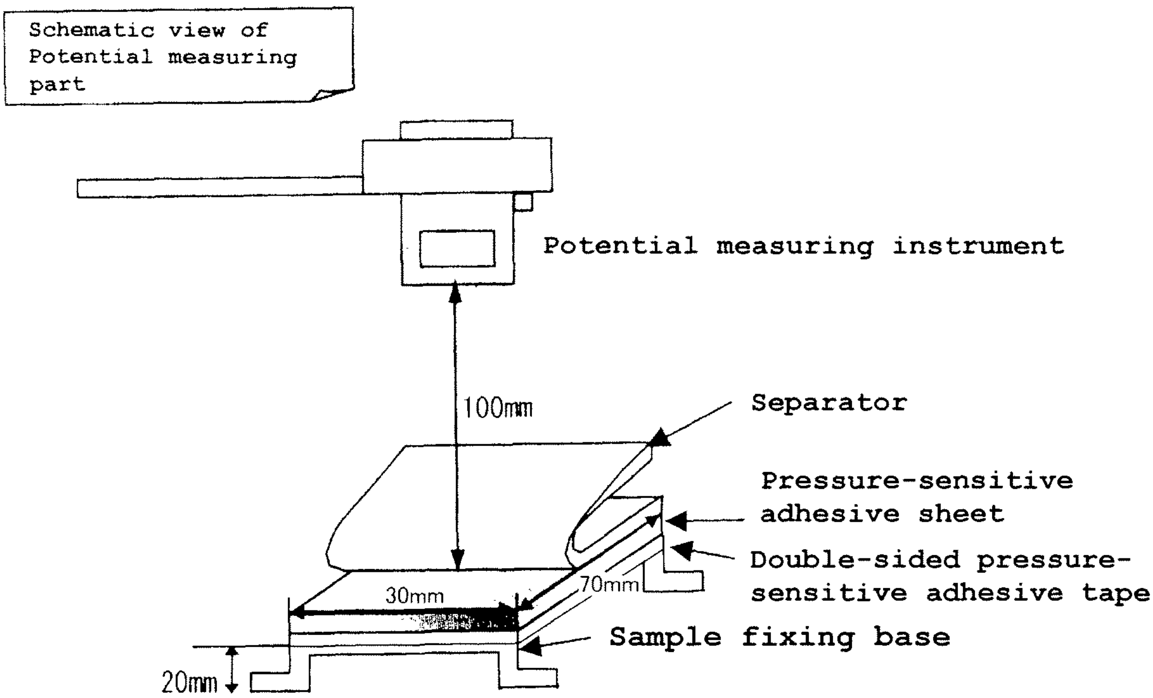
Schematic view of
Potential measuring
part
Potential measuring instrument
100mm
Separator
Pressure-sensitive
adhesive sheet
Double-sided pressure-
sensitive adhesive tape
30mm
70mm
Sample fixing base
20mm

## INTERNATIONAL SEARCH REPORT

International application No.
PCT/JP2011/067873

A. CLASSIFICATION OF SUBJECT MATTER
*H01L21/301*(2006.01)i, *C09J7/02*(2006.01)i, *C09J133/04*(2006.01)i, *H01L21/683*(2006.01)i

According to International Patent Classification (IPC) or to both national classification and IPC

B. FIELDS SEARCHED

Minimum documentation searched (classification system followed by classification symbols)
H01L21/301, C09J7/02, C09J133/04, H01L21/683

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 63-299246 A (FSK Kabushiki Kaisha), 06 December 1988 (06.12.1988), page 2, upper left column, lines 2 to 18; page 3, lower right column, line 15 to page 4, lower right column, line 19; page 6, lower right column, line 7 to page 8, upper right column, line 12 (Family: none) | 1,5-8 |
| Y | JP 2007-031534 A (Denki Kagaku Kogyo Kabushiki Kaisha), 08 February 2007 (08.02.2007), paragraphs [0036] to [0041] (Family: none) | 1,5-8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 23 August, 2011 (23.08.11) | 06 September, 2011 (06.09.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2011/067873

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2002-285134 A (Sumitomo Bakelite Co., Ltd.), 03 October 2002 (03.10.2002), claim 1 (Family: none) | 1,5-8 |
| Y | JP 2003-105292 A (The Furukawa Electric Co., Ltd.), 09 April 2003 (09.04.2003), paragraphs [0014], [0030] to [0037] & TW 574337 B & KR 10-2003-0004136 A & CN 1394930 A | 1,5-8 |
| Y | WO 2006/123638 A1 (Nitto Denko Corp.), 23 November 2006 (23.11.2006), claim 1; paragraphs [0065], [0072] to [0073]; examples & JP 2006-348273 A & US 2009/0029162 A1 & EP 1884547 A1 & KR 10-2008-0027263 A & CN 101175830 A | 2-4 |
| Y | JP 2005-290357 A (Nitto Denko Corp.), 20 October 2005 (20.10.2005), claim 1; paragraphs [0032], [0034], [0039]; examples & JP 2010-001497 A & US 2005/0197450 A1 & EP 1582573 A2 & EP 1889889 A2 & EP 2246404 A1 & KR 10-2006-0043541 A & KR 10-2010-0122885 A & KR 10-2010-0122886 A & CN 1667071 A | 2-4 |
| A | JP 02-139927 A (Nitto Denko Corp.), 29 May 1990 (29.05.1990), claim 1; fig. 1 to 3 (Family: none) | 1,5-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002285134 A


### Non-patent literature cited in the description


- Ionic liquid-The Front and Future of Development. CMC